# EUROPEAN PATENT SPECIFICATION

(11) **EP 1 018 566 B1**
(45) Date of publication and mention of the grant of the patent: **13.05.2009**
(21) Application number: 99124348.6
(22) Date of filing: 06.12.1999
(51) Int. Cl.: C23C 14/34, H01J 37/34, C04B 35/58

(54) **Sputtering target and method for the manufacture thereof**
Target für die Kathodenzerstäubung und Verfahren zur Herstellung eines solchen Targets
Cible de pulvérisation cathodique et son procédé de fabrication

(30) Priority: 08.01.1999 JP 267799
(43) Date of publication of application: 12.07.2000
(73) Proprietor: Nippon Mining & Metals Co., Ltd., Minato-ku Tokyo (JP)
(72) Inventor: Takahashi, Hideyuki, Isohara Plant of Nikko Mat., Kitaibaraki-shi, Ibaraki-Ken 319-1535 (JP); Ohhashi, Tateo, Isohara Plant of Nikko Mat. Comp., Kitaibaraki-shi, Ibaraki-Ken 319-1535 (JP); Seki, Kazuhiro, Isohara Plant of Nikko Mat. Comp., Kitaibaraki-shi, Ibaraki-Ken 319-1535 (JP)
(74) Representative: Hoarton, Lloyd Douglas Charles

(56) References cited:
- EP-A- 0 483 375
- EP-A- 0 872 572
- EP-A- 0 902 102
- PATENT ABSTRACTS OF JAPAN vol. 1999, no. 02, 26 February 1999 (1999-02-26) & JP 10 310470 A (MITSUBISHI MATERIALS CORP), 24 November 1998 (1998-11-24)
- PATENT ABSTRACTS OF JAPAN vol. 1998, no. 11, 30 September 1998 (1998-09-30) & JP 10 158829 A (SONY CORP), 16 June 1998 (1998-06-16)

## Description

### BACKGROUND OF THE INVENTION

### Field of the Invention

The present invention relates to a sputtering target having a stable film deposition rate from the initial stage of sputtering, and enabling to eliminate the need for burn-in, or pre-sputtering by practically removing the surface-deformed layer of the sputtering target, and making the surface of the sputtering target in the state suitable for sputtering. The present invention also relates to a method for manufacturing such a sputtering target.

### Description of the Prior Art

Heretofore, the surface of a sputtering target has been finished by machining, such as cutting, grinding, or polishing.

Due to the characteristics of such machining by forcedly processing while physically breaking metal crystal grains, a large number of strains and defects, known as surface-deformed layer, remain on the surface of the target.

Since sputtering is a process for releasing metal atoms constituting the target by using collision energy generated by physically colliding cations such as Ar+ to a target installed on a cathode, the ease of releasing the metal atoms themselves differs depending upon the arrangement of metal atoms in a crystal (crystal orientation).

In a sputtering target having remaining machining-affected layers as described above, a stable surface state is obtained only after the target has been used for a certain period of time, and the film deposition rate is stabilized.

Therefore, as long as surface-deformed layers remain, the deposition rate cannot be stabilized, causing the integrated input electric energy required for pre-sputtering to increase.

In order to solve such problems, a method for removing surface-deformed layers by etching the target surface has been proposed (Japanese Patent Laid-Open No. 7-118842).

However, such a method has a problem in which the integrated input electric energy required for pre-sputtering cannot be decreased sufficiently by rigorous etching under conditions suitable for removing surface-deformed layers.

### BRIEF SUMMARY OF THE INVENTION

### Object of the Invention

In order to solve the above-described problems, in particular to realize the quick stabilization of the film deposition rate, the object of the present invention is to provide a sputtering target having a desired surface state for realizing the stable film deposition rate from the initial stage of the use of the sputtering target, and a method for manufacturing such a sputtering target.

### SUMMARY OF THE INVENTION

The inventors of the present invention conducted repeated examinations for solving the above-described problems, and obtained the following findings.

In the state where the film deposition rate is stabilized after a sputtering target has been used for a certain period of time, a microscopic crystal surface, from which metal atoms are easily released by sputtering, covers the surface of the target subjected to erosion, and such a crystal surface appears one after another even after sputtering has been proceeded.

Unless the surface of the target has been covered with a crystal surface that is easily sputtered, even though the surface roughness of the target is minimized, for example, by mirror polishing, or even in the state where no surface-deformed layers are present, integrated input electric power until the film deposition rate is stabilized cannot be decreased to zero (from the behavior of Comparative Example (3) described later).

If a surface-deformed layer remains, the film deposition rate when the area is undergone sputtering is higher than the film deposition rate when stabilized. Therefore, the surface-deformed layer must be removed to substantially zero.

Even if there is no surface-deformed layer, a state where the surface of the target is covered with the crystal surface that is easily sputtered cannot be obtained if the target surface is excessively rough, and pre-sputtering is required until such a state is obtained (from the behavior of Comparative Example (5) described later).

By decreasing the surface-deformed layer to practically zero by etching after precision machining for minimizing the surface-deformed layer, and by etching until the state where the surface of the target is covered with the crystal surface that is easily sputtered is obtained, a target consuming little integrated input electric power until the film deposition rate is stabilized can be obtained.

On the basis of the above described findings, according to a first aspect of the present invention, there is provided a sputtering target free of the surface-deformed layer formed by machining on the surface thereof subjected to erosion, wherein the surface roughness (Ra) defined by the mean roughness on the center line of said surface is in a range between 1.0% and 10% of the mean crystal grain diameter of the material constituting the target.

According to a second aspect of the present invention, there is provided a method for manufacturing a sputtering target comprising the steps of reducing the surface-deformed layer to a thickness of 20µm or less by the precision machining of the surface of the sputtering target subjected to erosion, and making the surface roughness Ra be in a range between 1.0% and 10% of the mean crystal grain diameter of the material constituting the target by etching.

### BRIEF DESCRIPTION OF THE DRAWING

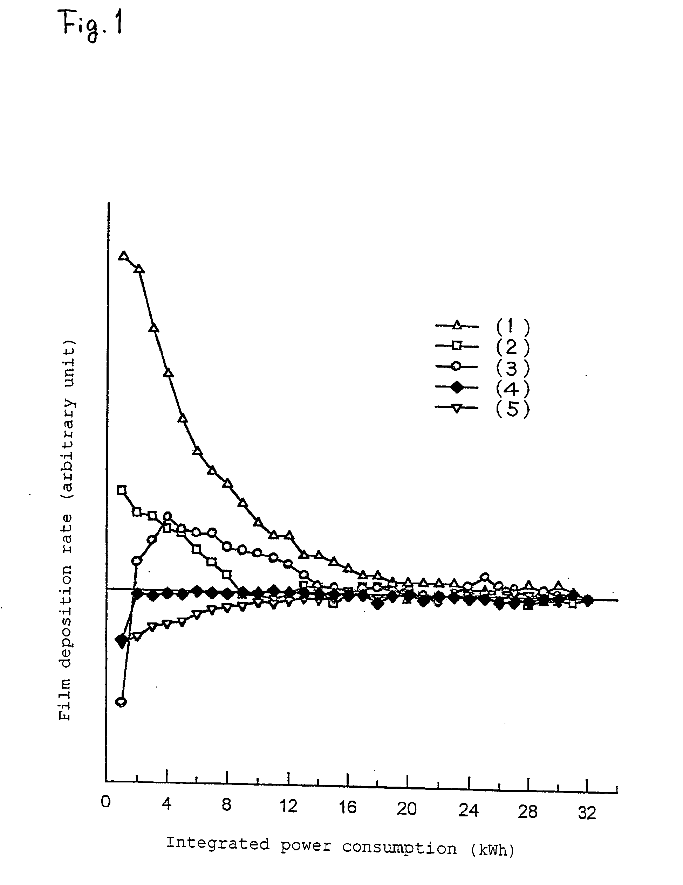

FIG. 1 is a graph showing the relationship between integrated electric power consumption and film deposition rate of the Embodiment and Comparative Embodiments of the present invention.

### DETAILED DESCRIPTION OF THE PREFERRED EMBODIMENT

Next, the present invention will be described in detail referring to Embodiment, Comparative Embodiments, and the drawings.

### (Embodiment and Comparative Embodiments)

Ti targets having a purity of 99.995% by weight, and a mean crystal grain diameter of 40 µm were used for the examinations. Five samples having the states of surface finishing of (1) ordinary lathe finishing; (2) ordinary lathe finishing + wet polishing; (3) precision lathe finishing; (4) precision lathe finishing + wet polishing + chemical etching; and (5) precision lathe finishing + chemical etching (a large amount of etching) were prepared.

Properties of the samples are shown in Table 1. As Table 1 shows, (4) is the Embodiment of the present invention, and (1), (2), (3), and (5) are Comparative Examples.

Surface roughness was measured by a contact roughness meter, and the thickness of the surface-deformed layer was estimated by an X-ray diffractometer.

Chemical etching was carried out by immersing the samples for 60 seconds in a mixed solution of 5% by volume hydrofluoric acid, 15% by volume nitric acid, and 80% by volume water.

**[Table 1]**

| | Symbol | Mean roughness on the center line Ra (µm) | Thickness of machining-affected layer (µm) | Relative ratio (%) roughness/grain diameter |
|---|---|---|---|---|
| Comparative Example | (1) | 4 | 30 | 10 |
| Comparative Example | (2) | 0.4 | 15 | 1 |
| Comparative Example | (3) | 0.1 | 20 | 0.25 |
| Example | (4) | 0.7 | 0 | 1.75 |
| Comparative Example | (5) | 20 | 0 | 50 |

The film deposition rate plotted for integrated electric energy are shown in FIG. 1. For samples (1) and (2), the surface-deformed layer those are easily sputtered are thick, and the film forming speed is high in the initial stage of the use of the sputtering target.

That is, since a large number of surface-deformed layers remain in the sample (1), the film deposition rate is high in the initial stage, and the film deposition rate becomes the almost stable (normal) state when integrated electric energy reaches about 20 kWh.

For the sample (2), integrated electric power until the stable state of the film deposition rate is decreased by the smaller number of surface-deformed layers compared with the sample (1), and the film deposition rate becomes almost stable when integrated electric energy reaches about 10 kWh.

Whereas, although the surface-deformed layer of the sample (3) are thinner (20 µm) than those of the sample (1) and thus approach a favorable surface, surface roughness is small (mirror-finishing), thus sputtering becomes difficult in the initial stage of use, and the film deposition rate is lowered. (In this case, the mean roughness Ra on the center line of the target is 0.25% of the mean crystal grain diameter.)

Thereafter, since surface-deformed layers of about 20 µm remain, the film deposition rate increases once, then it is stabilized when integrated electric energy reaches about 16 kWh. Such variations in the film deposition rate are not preferable.

It is seen in the sample (4), an Embodiment of the present invention, that although almost all the surface-deformed layer have been removed by etching, and the film deposition rate is low until integrated electric power reaches about 1 kWh where the naturally oxidized layer on the uppermost surface is removed, thereafter the film deposition rate is highly stabilized. (In this case, the surface roughness Ra is 1.75% of the mean crystal grain diameter.)

It is seen that the stable film deposition rate is obtained from the very initial stage of the use of the sputtering target according to the present invention.

Although the Comparative Example (5) has no surface-deformed layers, the amount of etching is large, and surface roughness is large. Therefore, the film deposition rate is low in the initial stage of use, and thereafter, it is almost stabilized when integrated electric energy reaches about 14 kWh.

As described above, in the samples after the surface-deformed layer of the surface of the sputtering target have been decreased, and then adequately etched for obtaining a state close to the state where the surface is covered with an orderly crystal surface suitable for sputtering, the film deposition rate is kept stabilized from the initial stage of use.

Next, Table 2 shows the relationship between the surface roughness Ra, the ratio of the surface roughness Ra to the particle diameter, and integrated electric power until the film deposition rate becomes stabilized. In Table 2, A, B, C, F, and G are Comparative Examples and D and E are the Embodiments of the present invention.

**[Table 2]**

| | Mean roughness on the center line Ra (µm) | Relative ratio (%) roughness/grain diameter | Integrated power consumption (kWh) | Thickness of machining-affected layer (µm) |
|---|---|---|---|---|
| A | 0.004 | 0.01% | 20 | 10 |
| B | 0.02 | 0.05% | 16 | 10 |
| C | 0.04 | 0.1% | 8 | 0 |
| D | 0.4 | 1.0% | 2 | 0 |
| E | 4 | 10% | 3 | 0 |
| F | 20 | 50% | 14 | 0 |
| G | 32 | 80% | 18 | 0 |

In Comparative Examples A and B, the surface roughness of the above-described Comparative Example C is further decreased, that is mirror-polished. Although the integrated electric power of Comparative Example B until the film deposition rate is stabilized is about 16 kWh, almost the same as that of Comparative Example C, that of Comparative Example A which has been mirror-polished is increased to about 20 kWh.

In Examples D, and E, and Comparative Examples C, F and G, surface roughness has been changed by changing etching time in Example (4), and the Comparative Example F corresponds to Comparative Example (5).

Integrated electric power until the film deposition rate of Examples D, and E, and Comparative Examples C, F and G is stabilized is 2, 3, 8, 14, and 18 kWh, respectively, and it is seen that the preferable ratio of the surface roughness Ra to the grain diameter is within a range between 1.0% and 10%.

It is seen from this that the favorable film deposition rate in excessive etching does not result in more stabilized target materials.

As described above, the present invention realizes the surface approximate to the normal state of sputtering in the initial stage of manufacturing the target, and makes the surface of the sputtering target a surface having exposed more or less uneven texture of crystal grains.

In the target thus manufactured, sputtering proceeds in ordinary sputtering, and the surface same as or similar to the sputtered surface in the normal state is obtained.

According to the present invention, as described above, a sputtering target for the stabilized film deposition rate from the initial stage of sputtering can be provided by making the surface of the sputtering target the state close to a state where the surface has exposed uneven texture of crystal grains, rather than removing almost all of the surface-deformed layer and mirror-polishing the surface.

## Claims

1. A sputtering target comprising a surface to be subjected to erosion, said surface being free of a surface-deformed layer and having a surface roughness (Ra), defined as a mean roughness on a center line of said surface, in a range between 1.0% to 10% of the mean crystal grain diameter of a material constituting said target.

2. A method of manufacturing a sputtering target comprising the steps of:
reducing a surface-deformed layer to a thickness of 20µm or less by precision machining a surface of the sputtering target to be subjected to erosion; and
etching said surface to remove the surface-deformed layer and to provide said surface with a surface roughness (Ra), defined as a mean roughness on the center line of said surface, in a range between 1.0% to 10% of the mean crystal grain diameter of a material constituting said target.

## Patentansprüche

1. Target für die Kathodenzerstäubung, umfassend eine Oberfläche, die der Erosion ausgesetzt werden soll, wobei diese Oberfläche frei von einer oberflächendeformierten Schicht ist und eine Oberflächenrauigkeit (Ra), welche definiert ist als eine mittlere Rauigkeit auf einer Mittellinie der Oberfläche, hat, die in einem Bereich zwischen 1,0 % und 10 % des mittleren Kristallkorndurchmessers eines Materials liegt, aus welchem das Target gebildet ist.

2. Verfahren zur Herstellung eines Targets für die Kathodenzerstäubung, umfassend die folgenden Schritte:
das Reduzieren einer oberflächendeformierten Schicht auf eine Dicke von 20 µm oder weniger durch Feinbearbeitung einer Oberfläche des Targets für die Kathodenzerstäubung, die der Erosion ausgesetzt werden soll; und
das Ätzen der Oberfläche, um die oberflächendeformierte Schicht zu entfernen und um die Oberfläche mit einer Oberflächenrauigkeit (Ra), welche definiert ist als eine mittlere Rauigkeit auf einer Mittellinie der Oberfläche, zu versehen, die in einem Bereich zwischen 1,0 % und 10 % des mittleren Kristallkorndurchmessers eines Materials liegt, aus welchem das Target gebildet ist.

## Revendications

1. Une cible de pulvérisation comportant une surface devant être soumise à érosion, ladite surface étant dépourvue d'une couche à surface déformée et ayant une rugosité de surface (Ra), définie comme rugosité moyenne sur une ligne centrale de ladite surface, allant de 1,0 % à 10 % du diamètre de grain cristallin moyen d'un matériau constituant ladite cible.

2. Un procédé pour fabriquer une cible de pulvérisation comportant les étapes visant à :
réduire une couche à surface déformée à une épaisseur de 20 µm ou moins, en usinant avec précision une surface de la cible de pulvérisation devant être soumise à érosion ; et
attaquer ladite surface à l'acide pour enlever la couche à surface déformée et pour donner à ladite surface une rugosité de surface (Ra), définie comme rugosité moyenne sur la ligne centrale de ladite surface, allant de 1,0 % à 10 % du diamètre de grain cristallin moyen d'un matériau constituant ladite cible.
